# EUROPÄISCHE PATENTANMELDUNG

(11) **EP 0 864 374 A2**
(43) Veröffentlichungstag der Anmeldung: **16.09.1998**
(21) Anmeldenummer: 98103427.5
(22) Anmeldetag: 27.02.1998
(51) Int. Cl.: B05D 7/24, C23C 16/40, A61C 13/083

(54) **Verfahren zur Behandlung von Oberflächen**

(30) Priorität: 11.03.1997 DE 19709673
(71) Anmelder: Heraeus Kulzer GmbH, 63450 Hanau (DE)
(72) Erfinder: Oppawsky, Steffen, 61350 Bad Homburg (DE); Schödel, Dieter, Dr., 65193 Wiesbaden (DE); Tiller, Hans-Jürgen, Prof. Dr., 07749 Jene (DE)
(74) Vertreter: Kühn, Hans-Christian

(57) **Zusammenfassung**

Die Erfindung betrifft ein Verfahren zur Behandlung von Oberflächen und oberflächennahen Schichten von insbesondere Dentalteilen, bei dem durch eine Aufeinanderfolge mehrerer unterschiedlicher Plasmabehandlungen eine hohe Haftfestigkeit zwischen der Plasma behandelten Oberfläche und einer danach aufgebrachten Kunststoffschicht erzielt wird. Desweiteren betrifft die Erfindung ein Verfahren, bei dem die Oberfläche eines Werkstückes mit Hilfe einer Plasmabehandlung mit einer silikathaltigen Schicht bedeckt und damit versiegelt wird.

## Beschreibung

Die Erfindung betrifft ein Verfahren zur Behandlung von Oberflächen und oberflächennahen Schichten von Werkstücken, insbesondere von Dentalteilen, mit einem Plasma eines Gases, bei dem das Werkstück dem Plasma ausgesetzt wird und bei dem Bestandteile des Gases mittels des Plasmas mit der Oberfläche des Werkstückes fest verbunden werden, wobei danach ein Kunststoff auf die Oberfläche aufgebracht wird. Die Erfindung betrifft weiterhin ein Verfahren zur Behandlung von Oberflächen von Werkstücken, insbesondere von Dentalteilen mit einem Plasma eines Gases, bei dem das Werkstück dem Plasma ausgesetzt wird und bei dem Bestandteile des Gases mittels des Plasmas mit der Oberfläche des Werkstückes fest verbunden werden.

Ein derartiges Verfahren ist aus der DD-PS 213 573 bekannt. Hier ist beschrieben, daß Metalloberflächen einem Plasma ausgesetzt werden, dem ein Silan Zugesetzt ist. Dadurch bildet sich auf der Metalloberfläche eine Haftvermittlerschicht, die eine sichere, aber elastische Verbindung zwischen der Metalloberfläche und einem darauf aufzutragenden Kunststoff bewirkt. Die nach diesem Verfahren erzielten Festigkeiten haben sich in der Praxis jedoch nicht immer als ausreichend erwiesen. Außerdem erfordert das bekannte Verfahren eine Metalloberfläche als Grundlage des Schichtenaufbaus; eine Reparatur von bereits bestehenden Metall/Kunststoff-Aufbauten, bei denen beispielsweise Kunststoff abgeplatzt ist, so daß die Oberfläche sowohl aus Kunststoff als auch aus Metall besteht, führt mit diesem Verfahren nicht zu zufriedenstellenden Ergebnissen. Es ist auch bekannt, derartige Haftvermittlungsschichten durch Flammenpyrolyse auf ein Metallgerüst aufzubringen. Bei der Anwendung der Flammenpyrolyse erwärmt sich das Metallgerüst jedoch sehr stark, was zu einem unerwünschten Wärmeverzug führen kann. Außerdem können mit diesem Verfahren keine Reparaturen an Oberflächen, die mindestens zum Teil aus einem Kunststoff bestehen, durchgeführt werden.

Aus US 5,188,800 ist es bekannt, Metalloberflächen mittels eines Plasmas zu reinigen. Die DE 33 16 742 offenbart neben einem Verfahren zur Plasmareinigung von Metalloberflächen auch das Beschichten mit Titan.

Ausgehend von dem oben beschriebenen Stand der Technik liegt der Erfindung die Aufgabe zugrunde, das Plasmabehandlungsverfahren derart weiterzuentwickeln, daß es möglich wird, die Oberfläche eines Werkstückes mit einer zuverlässig haftenden silikathaltigen Schicht zu versehen.

Die Aufgabe wird erfindungsgemäß für ein Verfahren gemäß dem Oberbegriff des Anspruchs 1 dadurch gelöst, daß die Oberfläche zuerst einem Plasma ausgesetzt wird, das aus einem Luft, Sauerstoff, Wasserdampf und/oder Inertgas enthaltenden Gas gebildet wird, daß danach ein Gas zur Bildung des Plasmas verwendet wird, dem eine siliziumorganische Verbindung Zugesetzt wird, wobei eine silikathaltige Schicht auf der Oberfläche des Werkstückes ausgebildet wird und daß anschließend ein Gas zur Bildung des Plasmas verwendet wird, das im wesentlichen Luft, Sauerstoff, Wasserdampf und/oder Inertgas enthält. Durch dieses Verfahren wird die Oberfläche des Werkstückes zunächst aktiviert, danach findet die sogenannte Silanisierung, das Auftragen einer silikathaltigen Schicht, statt und anschließend erfolgt eine Nachaktivierung. Im Anschluß daran erfährt das Werkstück die klassische Weiterverarbeitung, das heißt, es wird mit einem Kunststoff beschichtet. Die erfindungsgemäße Aufeinanderfolge mehrerer Verfahrensschritte bewirkt eine ausgezeichnete Haftung zwischen dem Werkstück und dem darauf aufgebrachten Kunststoff. Es können beispielsweise metallische Zahnprothesen-Grundgerüste mit Kunststoff verblendet werden unter Ausbildung eines sehr festen Haftverbundes Zwischen der Metalloberfläche und dem Kunststoff. Das Verfahren kann auch verwendet werden zur Behandlung von Kunststoffoberflächen oder von Oberflächen, die sowohl metallische Flächenanteile als auch Kunststoff aufweisen, beispielsweise bei der Reparatur von Zahnprothesen oder einzelnen Zähnen. Die Behandlung von Kunststoffoberflächen ist möglich, da die zu behandelnden Oberflächen bei der Plasmabehandlung eine relativ geringe Temperatur (ca. 100°C) aufweisen. Zweckmäßigerweise erfolgt die Behandlung mit Plasma in einem Vakuum von 0,01 bis 10 mbar, insbesondere von 0,1 bis 5 mbar, erfolgt. Die Behandlungszeit mit jedem Gasgemisch, also in jedem der drei Verfahrensschritte beträgt zwischen 10 und 300 s, insbesondere 20 bis 60 s, wobei die Leistungsdichte zwischen 2 und 5000 mW pro cm² zu behandelnder Fläche, insbesondere zwischen 1000 und 4000 mW/cm², liegt. Als besonders vorteilhaft hat es sich erwiesen, daß die siliziumorganische Verbindung dem Gas in einem Anteil von 0,01 bis 50 mol%, insbesondere von 0,1 bis 30 mol%, bezogen auf das Gas, zugemischt wird. Die siliziumorganische Verbindung kann beispielsweise Tetraethoxysilan, Tetramethylsilan oder Hexamethyldisiloxan sein.

Desweiteren kann es vorteilhaft sein, das Plasma durch eine Wechselstromentladung mit einer Frequenz von 10 Hz bis 60 kHz, insbesondere von 30 Hz bis 20 kHz, oder durch eine Mikrowellenentladung zu erzeugt. Ebenso kann es zweckmäßig sein, daß das Werkstück nach der Plasmabehandlung einem Druck in Höhe von 0,01 bis 1mbar während einer Zeitdauer von 10 bis 300s und/oder einer Temperatur in Höhe von 50 bis 120°C während einer Zeitdauer von 20 bis 60s ausgesetzt wird. Durch die Druck- bzw. Vakuumbehandlung kann die Ausbildung einer Dispersionsschicht auf einem Dentalkunststoff während einer Lichthärtung vermieden werden. Derartige Schichten sind während eines Schichtaufbaues von Dentalkunststoffen zwar gewünscht, bei der Versiegelung der Oberfläche jedoch störend. Die Dispersionsschicht kann auch dadurch vermieden werden, daß die das mit Kunststoff beschichtete Werkstück enthaltende Prozeßkammer (in der das Verfahren abläuft) mit einem Inertgas, vorzugsweise mit Stickstoff, belüftet und das Werkstück gleichzeitig oder der Belüftung folgend belichtet wird.

Die Aufgabe wird für ein Verfahren zur Behandlung von Oberflächen von Werkstücken, insbesondere von Dentalteilen mit einem Plasma eines Gases, bei dem das Werkstück dem Plasma ausgesetzt wird und bei dem Bestandteile des Gases mittels des Plasmas mit der Oberfläche des Werkstücks fest verbunden werden, dadurch gelöst, daß die Oberfläche des Werkstückes aus einem Kunststoff oder aus Keramik gebildet ist, daß das Gas Luft, Sauerstoff, Wasserdampf und/oder Inertgas sowie eine siliziumorganische Verbindung enthält und daß die Oberfläche des Werkstückes mindestens teilweise mit einer in sich geschlossenen silikathaltigen Schicht bedeckt wird. In dieser Form eignet sich das Verfahren zur Oberflächenversiegelung. Insbesondere die Qualität von Kunststoffoberflächen, beispielsweise von Kunststoffverblendungen von Zahnprothesen, kann durch eine derartige Oberflächenbeschichtung wesentlich verbessert werden hinsichtlich Härte, Abriebfestigkeit, Löslichkeit usw. Dafür ist es zweckmäßig, daß die siliziumorganische Verbindung dem Gas in einem Anteil von 20 bis 90 mol%, insbesondere von 30 bis 80 mol%, zugemischt wird. Weiterhin ist es vorteilhaft für einen optimalen Oberflächenschutz, daß die silikathaltige Schicht mit einer Dicke von 0,1 bis 5 µm, insbesondere von 0,3 bis 3 µm, ausgebildet wird. Weitere vorteilhafte Ausgestaltungen der Erfindung sind in den Unteransprüchen angegeben.

Für ein Verfahren zur Behandlung von Werkstücken, insbesondere von Dentalteilen, mit einem Plasma eines Gases, bei dem das Werkstück dem Plasma ausgesetzt wird, wird die Aufgabe dadurch gelöst, daß das Werkstück mit einem lichtpolymerisierbaren Kunststoff, insbesondere mit einem Dentalkunststoff beschichtet wird, daß das Gas Luft, Sauerstoff, Wasserdampf und/oder Inertgas enthält und daß die Schicht aus Kunststoff unter Einwirkund des Plasmas und von Lichtstrahlung ausgehärtet wird. Zweckmäßigerweise können Plasma und Lichtstrahlung nacheinander einwirken. Besonders vorteilhaft für eine Aushärtung ist es, ultraviolette Lichtstrahlung zu verwenden. Dieses Verfahren kann im Anschluß an eine Behandlung nach den Ansprüchen 1 oder 10 durchgeführt werden. Der Plasmaprozeß bewirkt eine Aktivierung der Oberfläche des Kunststoffes, um eine Haftung mit einer eventuell darauf aufgebrachten Kunststoffschicht zu verbessern.

Weitere vorteilhafte Ausgestaltungen sind in den weiteren Unteransprüchen angegeben.

Nachfolgend wird die Erfindung anhand von Ausführungsbeispielen erläutert.

In den Beispielen 1 bis 4 wurde auf unterschiedlichen Dentallegierungen ein Kunststoffaufbau vorgenommen. Im Anschluß wurde die Zugscherfestigkeit in Abhängigkeit von der Kochzeit gemessen. Dabei wurde das mit dem erfindungsgemäßen Verfahren erzielte Ergebnis dem mit einem Verfahren nach dem Stand der Technik erzielten Ergebnis gegenübergestellt. Die Ergebnisse sind in Tabelle 1 dargestellt. Beispiel 1 beschreibt einen Aufbau auf der Dentallegierung "Maingold SG" (Heraeus Kulzer GmbH), Beispiel 2 einen Aufbau auf "Heraenium CE" (Heraeus Kulzer GmbH), Beispiel 3 einen Aufbau auf "Albabond E" (Heraeus Kulzer GmbH) und Beispiel 4 einen Aufbau auf "Hera GG" (Heraeus Kulzer GmbH). Die Versuche wurden in allen vier Fällen wie folgt durchgeführt. Das Plasma wurde bei einem Druck von 2 mbar und einer Spannung von 600 V gezündet. Der Strom betrug 50 mA, die Leistung 30 W. Die Werkstückfläche betrug 8 cm², die Flächenleistung 3,75 W/cm². Die Dentallegierung wurde nach dem bekannten Verfahren 60 Sekunden lang mit dem beschriebenen TMOS-Plasma (Tetramethoxysilan-Plasma) behandelt und gemäß dem erfindungsgemäßen Verfahren zuerst für 20 Sekunden mit Luftplasma, dann 60 Sekunden lang mit TMOS-Plasma und anschließend nochmals 20 Sekunden lang mit Luftplasma. Im Anschluß wurde auf die entstandene SiO₂-Schicht ein Primer (Siliseal von Heraeus Kulzer GmbH) aufgebracht (mit einem Pinsel), danach wurde ein Opaker (Artglass-Opaker von Heraeus Kulzer GmbH) aufgebracht und 90s mit UV-Licht polymerisiert. Anschießend wurde zweimal Dentin aufgebracht und jeweils 90s polymerisiert und danach wurde nochmals Dentin aufgebracht und 180s mit UV-Licht polymerisiert. Die Kunststoffschichtdicke betrug insgesamt 3 mm. Die Messung der Zugscherfestigkeit erfolgte in Anlehnung an DIN 53 286.

**Tabelle 1**

| (Zugscherfestigkeitswerte in MPa in Abhängigkeit von der Kochzeit) | | | | | |
|---|---|---|---|---|---|
| **Oberflächenbehandlung** | **0h** | **1h** | **8h** | **24h** | **48h** |
| | | | | | |

| Beispiel 1 | | | | | |
|---|---|---|---|---|---|
| 60s TMOS-Plasma | 17,27 | 14,64 | 7,64 | 4,65 | 2,13 |
| 20s Luft-, 60s TMOS-, 20s Luft-Plasma | 25,64 | 36,26 | 19,94 | 16,42 | 10,53 |
| | | | | | |

| Beispiel 2 | | | | | |
|---|---|---|---|---|---|
| 60s TMOS-Plasma | 28,60 | 20,60 | 15,00 | 12,00 | 8,70 |
| 20s Luft-, 60s TMOS-, 20s Luft-Plasma | 25,00 | 40,78 | 34,98 | 29,03 | 23,53 |
| | | | | | |

| Beispiel 3 | | | | | |
|---|---|---|---|---|---|
| 60s TMOS-Plasma | 15,88 | 12,20 | 7,40 | 4,65 | 2,13 |
| 20s Luft-, 60s TMOS-, 20s Luft-Plasma | 21,22 | 21,60 | 15,04 | 11,75 | 9,70 |
| | | | | | |

| Beispiel 4 | | | | | |
|---|---|---|---|---|---|
| 60s TMOS-Plasma | 25,79 | 16,74 | 10,30 | 8,20 | 4,60 |
| 20s Luft-, 60s TMOS-, 20s Luft-Plasma | 28,86 | 25,79 | 16,74 | 16,71 | 15,00 |

Wie der Tabelle 1 zu entnehmen ist, sind die Zugscherfestigkeitswerte der erfindungsgemäß behandelten Materialaufbauten wesentlich größer als die Festigkeitswerte, die mit einer Behandlung nach dem Stand der Technik erzielt werden können.

In den Beispielen 5 und 6 wird ein Verfahren zur Oberflächenversiegelung von Dentalteilen beschrieben. Im Anschluß an die Oberflächenversiegelung wurde die Zugscherfestigkeit der Versiegelungsschicht nach einem 24-stündigen Kochtest bestimmt. In Tabelle 2 sind die Ergebnisse dieser Beispiele dargestellt. Dabei wurde in beiden Beispielen das erfindungsgemäß erzielte Ergebnis (mit Versiegelung) einem Ergebnis gegenübergestellt, das bei gleicher Vorbehandlung ohne Versiegelung erzielt wurde. Beispiel 5 beschreibt einen Schichtenaufbau auf der Dentallegierung "Hera GG" (Heraeus Kulzer GmbH), auf die ein Primer (Siliseal von Heraeus Kulzer GmbH) aufgebracht wurde (mit einem Pinsel), danach wurde ein Opaker (Artglass-Opaker von Heraeus Kulzer GmbH) aufgebracht und 90s mit UV-Licht polymerisiert. Anschließend wurde zweimal Dentin aufgebracht und jeweils 90s polymerisiert und danach wurde nochmals Dentin aufgebracht und 180s mit UV-Licht polymerisiert. Die Kunststoffschichtdicke betrug insgesamt 3 mm. Beispiel 6 beschreibt einen dem Beispiel 5 ähnlichen Aufbau. Im Unterschied zu Beispiel 5 wurde bei Beispiel 6 vor dem Aufbringen des Primers eine Behandlung der Dentallegierung mit Plasma gemäß dem bei den Beispielen 1 bis 4 erläuterten erfindungsgemäßen Verfahren durchgeführt, so daß der Verbundwerkstoff nach Beispiel 6 auch ohne eine Versiegelung bessere Ergebnisse hinsichtlich der Zugscherfestigkeit aufweist als der entsprechende Aufbau in Beispiel 5. Die Versiegelung der Oberfläche des Werkstückaufbaus wurde in beiden Beispielen wie folgt durchgeführt. Das Plasma wurde bei einem Druck von 2 mbar und einer Spannung von 600 V gezündet. Der Strom betrug 50 mA, die Leistung 30 W. Die Werkstückfläche betrug 8 cm². Die genaue Flächenleistung bei Aufbringen einer Beschichtung auf eine Kunststoffschicht ist nicht ohne weiteres exakt bestimmbar, sie ist jedoch niedriger als bei einer Beschichtung auf Metall bei gleichen Plasmaparametern (Zündspannung, Strom, Leistung). In diesem Beispiel betrug die Flächenleistung etwa 1,88 W/cm². Als Plasma wurde ein TMS-Plasma (Tetramethoxysilan-Plasma) verwendet mit einem Anteil von 70 bis 90 mol% TMS in dem Silan-Luft-Gemisch. Die Behandlungszeit mit dem TMS-Plasma kann nahezu beliebig variiert werden. Sie bestimmt im wesentlichen die Dicke der Versiegelungsschicht. Die Wachstumsrate der Schicht betrug etwa 1 µm/min. In dem Beispiel betrug die Beschichtungszeit (Behandlungszeit) 120 s. Die dabei entstandene Versiegelungsschicht weist eine Dicke von 2 µm auf. Die Messung der Zugscherfestigkeit erfolgte in Anlehnung an DIN 53286.

**Tabelle 2**

| (Zugscherfestigkeitswerte in MPa nach 24 Stunden Kochtest) | |
|---|---|
| **Oberflächenbehandlung** | **24 h** |
| | |

| Beispiel 5 | |
|---|---|
| ohne Versiegelung | 3,00 |
| mit TMS-Versiegelung | 10,00 |
| | |

| Beispiel 6 | |
|---|---|
| ohne Versiegelung | 8,48 |
| mit TMS-Versiegelung | 11,64 |

In beiden Beispielen weist der Schichtenaufbau mit einer TMS-Versiegelung eine höhere Zugscherfestigkeit als ohne die erfindungsgemäße Versiegelung auf. Diese Versiegelung mit SiO₂ reduziert den Feuchtedurchtritt durch den Kunststoff und verbessert damit die Korrosionsstabilität des Verbundes. Die Versiegelungsschicht wirkt also als Permeationssperre von außen nach innen. In entgegengesetzter Richtung tritt eine ähnliche Wirkung auf, so daß der Austritt von Kunststoffbestandteilen aus dem Verbund zumindest stark eingeschränkt wird. Damit lassen sich durch die gemessenen Zugscherfestigkeiten indirekte Rückschlüsse auf die Wirksamkeit der Versiegelungsschicht ziehen.

## Patentansprüche

1. Verfahren zur Behandlung von Oberflächen und oberflächennahen Schichten von Werkstücken, insbesondere von Dentalteilen, mit einem Plasma eines Gases, bei dem das Werkstück dem Plasma ausgesetzt wird und bei dem Bestandteile des Gases mittels des Plasmas mit der Oberfläche des Werkstückes fest verbunden werden, wobei danach ein Kunststoff auf die Oberfläche aufgebracht wird, dadurch gekennzeichnet, daß die Oberfläche zuerst einem Plasma ausgesetzt wird, das aus einem Luft, Sauerstoff, Wasserdampf und/oder Inertgas enthaltenden Gas gebildet wird, daß danach ein Gas zur Bildung des Plasmas verwendet wird, dem eine siliziumorganische Verbindung zugesetzt wird, wobei eine silikathaltige Schicht auf der Oberfläche des Werkstückes ausgebildet wird und daß anschließend ein Gas zur Bildung des Plasmas verwendet wird, das im wesentlichen Luft, Sauerstoff, Wasserdampf und/oder Inertgas enthält.

2. Verfahren nach Anspruch 1, dadurch gekennzeichnet, daß die Behandlung mit Plasma in einem Vakuum von 0,01 bis 10 mbar, insbesondere von 0,1 bis 5 mbar, erfolgt.

3. Verfahren nach Anspruch 1 oder 2, dadurch gekennzeichnet, daß die Behandlungszeit mit jedem Gasgemisch jeweils 10 bis 300 s, insbesondere 20 bis 60 s, beträgt und daß die Leistungsdichte zwischen 2 und 5000 mW pro cm² zu behandelnder Fläche, insbesondere zwischen 1000 und 4000 mW/cm², liegt.

4. Verfahren nach einem der Ansprüche 1 bis 3, dadurch gekennzeichnet, daR die siliziumorganische Verbindung dem Gas in einem Anteil von 0,01 bis 50 mol%, insbesondere von 0,1 bis 30 mol%, bezogen auf das Gas, zugemischt wird.

5. Verfahren nach einem der Ansprüche 1 bis 4, dadurch gekennzeichnet, daß die siliziumorganische Verbindung Tetraethoxysilan, Tetramethylsilan oder Hexamethyldisiloxan ist.

6. Verfahren nach einem der Ansprüche 1 bis 5, dadurch gekennzeichnet, daß das Plasma durch eine Wechselstromentladung mit einer Frequenz von 10 Hz bis 60 kHz, insbesondere von 30Hz bis 20 kHz, oder durch eine Mikrowellenentladung erzeugt wird.

7. Verfahren nach einem der Ansprüche 1 bis 6, dadurch gekennzeichnet, daß das Werkstück nach der Plasmabehandlung einem Druck in Höhe von 0,01 bis 1mbar während einer Zeitdauer von 10 bis 300s und/oder einer Temperatur in Höhe von 50 bis 120°C während einer Zeitdauer von 20 bis 60s ausgesetzt wird.

8. Verwendung des Verfahrens nach Anspruch 1 zur Behandlung von Metalloberflächen.

9. Verwendung des Verfahrens nach Anspruch 1 zur Behandlung von Kunststoffoberflächen.

10. Verfahren zur Behandlung von Oberflächen von Werkstücken, insbesondere von Dentalteilen mit einem Plasma eines Gases, bei dem das Werkstück dem Plasma ausgesetzt wird und bei dem Bestandteile des Gases mittels des Plasmas mit der Oberfläche des Werkstückes fest verbunden werden, dadurch gekennzeichnet, daß die Oberfläche des Werkstückes aus einem Kunststoff oder aus Keramik gebildet ist, daß das Gas Luft, Sauerstoff, Wasserdampf und/oder Inertgas sowie eine siliziumorganische Verbindung enthält und daß die Oberfläche des Werkstückes mindestens teilweise mit einer in sich geschlossenen silikathaltigen Schicht bedeckt wird.

11. Verfahren nach Anspruch 10, dadurch gekennzeichnet, daß die Behandlung mit Plasma in einem Vakuum von 0,01 bis 10 mbar, insbesondere von 0,1 bis 5 mbar, erfolgt.

12. Verfahren nach Anspruch 10 oder 11, dadurch gekennzeichnet, daß die siliziumorganische Verbindung dem Gas in einem Anteil von 20 bis 90 mol%, insbesondere von 30 bis 80 mol%, zugemischt wird.

13. Verfahren nach einem der Ansprüche 10 bis 12, dadurch gekennzeichnet, daß die siliziumorganische Verbindung Tetraethoxysilan, Tetramethylsilan oder Hexamethyldisiloxan ist.

14. Verfahren nach einem der Ansprüche 10 bis 13, dadurch gekennzeichnet, daß die silikathaltige Schicht mit einer Dicke von 0,1 bis 5 µm, insbesondere von 0,3 bis 3 µm, ausgebildet wird.

15. Verfahren nach einem der Ansprüche 10 bis 14, dadurch gekennzeichnet, daß die Beschichtungszeit 10 bis 300 s, insbesondere 20 bis 60 s, bei einer Leistungsdichte zwischen 2 und 5000 mW pro cm² zu behandelnder Fläche, insbesondere zwischen 1000 und 4000 mW/cm², beträgt.

16. Verfahren nach einem der Ansprüche 10 bis 15, dadurch gekennzeichnet, daß das Plasma durch eine Wechselstromentladung mit einer Frequenz von 10 Hz bis 60 kHz, insbesondere von 30Hz bis 20 kHz, oder durch eine Mikrowellenentladung erzeugt wird.

17. Verfahren nach einem der Ansprüche 10 bis 16, dadurch gekennzeichnet, daß das Werkstück nach der Plasmabehandlung einem Druck in Höhe von 0,01 bis 1mbar während einer Zeitdauer von 10 bis 300s und/oder einer Temperatur in Höhe von 50 bis 120°C während einer Zeitdauer von 20 bis 60s ausgesetzt wird.

18. Verfahren zur Behandlung von Werkstücken, insbesondere von Dentalteilen, mit einem Plasma eines Gases, bei dem das Werkstück dem Plasma ausgesetzt wird, dadurch gekennzeichnet, daß das Werkstück mit einem lichtpolymerisierbaren Kunststoff, insbesondere mit einem Dentalkunststoff beschichtet wird, daß das Gas Luft, Sauerstoff, Wasserdampf und/oder Inertgas enthält und daß die Schicht aus Kunststoff unter Einwirkung des Plasmas und von Lichtstrahlung ausgehärtet wird.

19. Verfahren nach Anspruch 18, dadurch gekennzeichnet, daß Plasma und Lichtstrahlung nacheinander einwirken.

20. Verfahren nach Anspruch 18 oder 19, dadurch gekennzeichnet, daß ultraviolette Lichtstrahlung verwendet wird.

21. Verfahren nach einem der Ansprüche 18 bis 20, dadurch gekennzeichnet, daß das mit Kunststoff beschichtete Werkstück mit einem Inertgas, vorzugsweise mit Stickstoff, belüftet und gleichzeitig oder der Belüftung folgend belichtet wird.

22. Verfahren nach einem der Ansprüche 18 bis 21, dadurch gekennzeichnet, daß die Behandlung mit Plasma in einem Vakuum von 0,01 bis 10 mbar, insbesondere von 0,1 bis 5 mbar, erfolgt.

23. Verfahren nach einem der Ansprüche 18 bis 22, dadurch gekennzeichnet, daß die Beschichtungszeit 10 bis 300 s, insbesondere 20 bis 60 s, bei einer Leistungsdichte zwischen 2 und 5000 mW pro cm² zu behandelnder Fläche, insbesondere zwischen 1000 und 4000 mW/cm², beträgt und daß die Beschichtung bei einem Druck von 0,01 bis 10 mbar, insbesondere von 0,1 bis 5 mbar erfolgt.

24. Verfahren nach einem der Ansprüche 18 bis 23, dadurch gekennzeichnet, daß das Plasma durch eine Wechselstromentladung mit einer Frequenz von 10 Hz bis 60 kHz, insbesondere von 30 Hz bis 20 kHz, oder durch eine Mikrowellenentladung erzeugt wird.
